# EUROPÄISCHE PATENTANMELDUNG

(11) **EP 1 160 554 A2**
(43) Veröffentlichungstag der Anmeldung: **05.12.2001**
(21) Anmeldenummer: 01111804.9
(22) Anmeldetag: 16.05.2001
(51) Int. Cl.: G01L 1/16

(54) **Verfahren zum Bestimmen von Signalen auf Schaltmatten, insbesondere auf Piezoschaltmatten**

(30) Priorität: 29.05.2000 DE 10026436
(71) Anmelder: Bircher AG, CH-8222 Beringen (CH)
(72) Erfinder: De Jager, Godert, 8604 Volketswil (CH)
(74) Vertreter: Weiss, Peter, Dr.

(57) **Zusammenfassung**

Bei einem Verfahren zum Bestimmen von Signalen, Gewichten, Kräften auf Schaltmatten, insbesondere auf kraft- oder druckbeaufschlagte Piezoschaltmatten, bei welchem ein Ausgangssignal, insbesondere eine Potentialdifferenz durch Druckbeaufschlagung erzeugt wird, welches ggf. zur Kraftmessung verstärkt wird, soll zur permanenten, kontinuierlichen Bestimmung von Signalen, von Gewichten, von Kräften die momentane Ladungsverschiebung (Qmess) ermittelt und zu dessen Kompensierung eine am Signalverstärker (4) zurückfliessende Ladung (Qab) zur Ermittlung der tatsächlichen ideelen Ladungsverschiebung (Qi) dazu addiert werden.

## Beschreibung

Die vorliegende Erfindung betrifft ein Verfahren zum Bestimmen von Signalen, Gewichten, Kräften auf Schaltmatten, insbesondere auf kraft- oder druckbeaufschlagte Piezoschaltmatten, bei welchem ein Ausgangssignal, insbesondere eine Potentialdifferenz durch Druckbeaufschlagung erzeugt wird, welches ggf. zur Kraftmessung verstärkt wird.

Bei herkömmlichen Schaltmatten, insbesondere bei piezobetriebenen Schaltmatten wird ein Ausgangssignal bei einer Kraftbeaufschlagung der Schaltmatte erzeugt. Im wesentlichen wird dabei über einen piezoähnlichen Effekt über eine Folie in der Schaltmatte bei Druckbeaufschlagung eine Ladungsverschiebung proportional zur Kraft erzeugt, welche eine Potentialdifferenz auf die Anschlüsse der Schaltmatte bewirkt.

Diese Potentialdifferenz wird mittel herkömmlichen Signalverstärkern, deren Eingangswiderstand nicht unendlich ist, gemessen.

Dabei wird die entstehende Potentialdiffernz nach einer gewissen Zeit wieder über den Eingangswiderstand des Signalverstärkers ausgeglichen. Das bedeutet, dass das Ausgangssignal verschwindet obwohl bspw. die Schaltmatte immer noch mit einer anliegenden Kraft beaufschlagt wird. Gerade in der Sicherheitstechnik kann dies ein grosser Nachteil sein, da nicht exakt messbar ist, ob die Kraft noch anliegt oder nicht. Zudem ist nachteilig, dass sich eine exakte Kraftmessung oder Kraftbestimmung hierdurch nicht realisieren lässt.

Der vorliegenden Erfindung liegt die Aufgabe zugrunde, ein Verfahren der eingangs genannten Art zu schaffen, welches die genannten Nachteile beseitigt und bei welchen permanent und zu jeder Zeit eine exakte Kraftmessung und Kraftbestimmung von druck- oder kraftbeaufschlagten Schaltmatten möglich ist. Dabei soll insgesamt in der Sicherheitstechnik die Zuverlässigkeit erhöht werden, es sollen mehrere unterschiedliche Informationen bspw. über die tatsächlich angelegte Kraft, die Kraftänderung zu jeder Zeit und an jedem Ort möglich sein.

Auch soll daran gedacht sein, bspw. eine exakte Kraft- oder Gewichtsmessung, eine Zählung von Personen, die über eine Schaltmatte gehen, zu verbessern.

Zur Lösung dieser Aufgabe führt, dass zur permanenten, kontinuierlichen Bestimmung von Signalen, von Gewichten, von Kräften die momentane Ladungsverschiebung Qmess ermittelt und zu dessen Kompensierung eine am Signalverstärker zurückfliessende Ladung Qab zur Ermittlung der tatsächlichen ideelen Ladungsverschiebung Qi dazu addiert wird.

Bei der vorliegenden Erfindung schliesst an eine Schaltmatte wenigstens ein Signalverstärker an. Diesem ist ein Microprozessor zugeordnet. An dem Signalverstärker wird durch Kraftbeaufschlagung der Schaltmatte eine momentane Ladungsverschiebung gemessen und über jeden Zeitabschnitt mittels des Microprozessors gemessen und bestimmt.

Gleichzeitig fliesst eine Ladung über den Signalverstärker zurück, wenn bspw. keine erneute Kraft mehr auf die Schaltmatte wirkt, oder die bestehende Kraft bzw. als konstant angelegte Kraft auf die Schaltmatte sich nicht ändert. Diese über den Signalverstärker zurückfliessende Ladung wird mittels des Microporzessors über jeden Zeitabschnitt gemessen und bestimmt.

Eine Bestimmung einer tatsächlichen ideelen Ladungsverschiebung der Schaltmatte, insbesondere bei Kraftbeaufschlagung, erfolgt unter Verwendung von Signalverstärkern mit endlichem Eingangswiderstand indem die Summe der über den Widerstand weggeflossene Ladung und der momentanen gemessenen Ladungsverschiebung am Signalverstärker in jedem Zeitpunkt aufaddiert und ermittelt werden.

Entscheidend bei der vorliegenden Erfindung ist, dass dieses Messverfahren eine ideele Ladungsverschiebung ermittelt, welche exakt proportional zur anliegenden Kraft der Schaltmatte ist.

Lässt die Kraft nach, so wird die ideele Ladungsverschiebung noch beim Nachlassen über jede Zeiteinheit ermittelt. Hierdurch kann exakt und genau festgelegt werden wann bspw. eine Person eine Schaltmatte betritt und wann zu welchem Zeitpunkt die Kraft nachlässt, wenn die Person die Schaltmatte verlässt.

Dabei kann über die ideele Ladungsverschiebung, die sich aus der Summe der über den Verstärker geflossenen Ladung und der momentanen Ladungsverschiebung ermittelt werden, die exakte Kraft bzw. auch ein exaktes Gewicht, welches auf die Schaltmatte wirkt, bestimmt und ermittelt werden.

Hierdurch lassen sich in der Sicherheitstechnik mehrere Anwendungen optimieren. Beispielsweise kann ein entsprechendes Signal zum Öffnen oder Schliessen einer Tür erst dann erzeugt werden, wenn ein ganz bestimmtes vorgegebenes Gewicht überschritten wird.

So ist bspw. eine Kindersicherung bei Türen oder Toren, die auf ein Signal einer Schaltmatte hin geöffnet oder verschlossen werden, möglich wenn ein ganz bestimmtes einstellbares und bestimmbares Gewicht überschritten wird. Dann erst wird eine Tür oder ein Tor entsprechend geöffnet oder verschlossen.

Auch können derartige Schaltmatten zum Wiegen von bspw. Personen oder von Fahrzeugen oder beliebigen Gegenständen verwendet werden. Hier sei der Erfindung keine Grenze gesetzt.

Auch ist denkbar über ein derartiges Verfahren eine exakte Personenzählung durchzuführen, da über die exakte Gewichtsbestimmung Mehrfachsignale, die ein Messergebnis verfälschen würden, sehr leicht ausgefilter werden können. Dies soll ebenfalls vom vorliegenden Erfindungsgedanken mit umfasst sein.
Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
Figur 1 eine schematisch dargestellte Seitenansicht auf eine Schaltmatte, insbesondere auf eine Kraft oder druckbeaufschlagbare Piezoschaltmatte;
Figur 2 ein Diagramm über den Spannungs- und Kraftverlauf einer druckbeaufschlagten Schaltmatte über die Zeit.

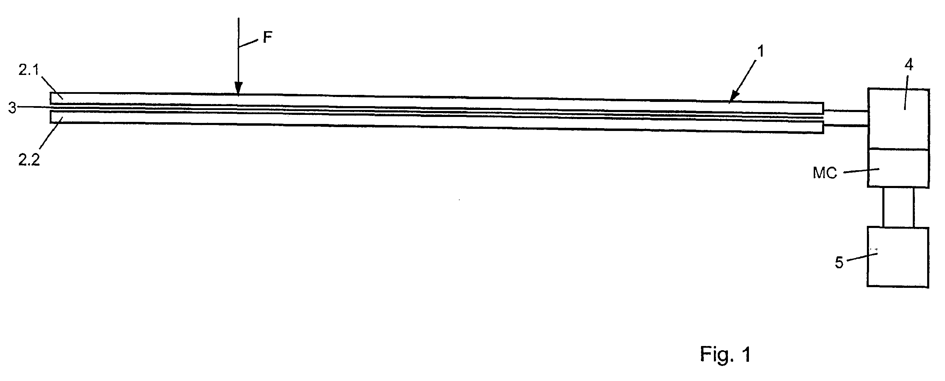

Gemäss Figur 1 ist eine Schaltmatte mittels einer beliebigen Kraft F beaufschlagbar.

Die Schaltmatte 1 besteht im wesentlichen aus zwei gegeneinander bewegbaren Elementen 2.1, 2.2, wobei bspw. bei Piezoschaltmatten zwischen den beiden Elementen 2.1, 2.2 eine Folie 3 dazwischen eingesetzt ist.

Wird eine Kraft F von Aussen auf die Schaltmatte 1, insbesondere auf das Element 2.1 angelegt, bspw. beim Begehen der Schaltmatte 1 oder bspw. beim Druckbeaufschlagen mittels eines beliebigen Gegenstandes, wird ein messbares Signal als Spannung oder Ladungsverschiebung an einem Signalverstärker 4 erzeugt.

Dabei wird mittels des Signalverstärkers 4 eine momentane Ladungsverschiebung Qmess bei Druck- oder Kraftbeaufschlagung mittels zumindest einer beliebigen Kraft auf die Schaltmatte 1 am Signalverstärker 4 über jeden beliebigen und wählbaren Zeitabschnitt gemessen und bestimmt.

Die momentane Ladungsverschiebung Qmess wird bestimmt über die am Signalverstärker 4 gemessene Ausgangsspannung sowie die Kapazität der Folie 3 der Schaltmatte 1. Hierzu wird ein Microprozessor MC verwendet, der die einzelnen Zeitabschnitte genau definiert, in welchen die Ladungsverschiebung Qmess bestimmt wird.

Gleichzeitig wird über jeden Zeitabschnitt die am Signalverstärker 4 nach einer unmittelbaren Kraftbeaufschlagung zurückfliessende Ladung Qab ebenfalls über den Microprozessor MC über jeden Zeitabschnitt bestimmt und gemessen.

Da bspw. bei herkömmlichen Piezoschaltmatten, nach einer einwirkenden Kraft F ein Signal erzeugt wird, welches eine Ladungsverschiebung verursacht, kann unmittelbar eine momentane Ladungsverschiebung Qmess bestimmt werden.

Bei andauernder und sich nicht ändernder Kraft, fliesst allerdings die Ladung, die am Signalverstärker 4 gemessen wird und dort anliegt, ab.

Hierdurch kann zwar lediglich unmittelbar bei Kraftbeaufschlagung auf eine Kraft F Rückschluss genommen werden, jedoch ist eine exakte Kraftbestimmung nicht möglich, auch wenn diese sich nach einer bestimmten Zeit wieder ändert, da die Ladung abfliesst.

Wird nun bspw. die am Signalverstärker zurückfliessende Ladung Qab permanent mittels eines Microprozessors MC über die Zeit gemessen und zur momentanen Ladungsverschiebung Qmess dazu addiert, resultiert eine ideele Ladungsverschiebung Qi. Die ideele Ladungsverschiebung Qi wird aus der Summe der über den Signalverstärker 4 geflossenen Ladung Qab und der momentanen Ladungsverschiebung Qmess in jedem Zeitabschnitt mittels des Microprozessors MC gebildet und ermittelt. Hierdurch lässt sich nach Ermittlung der ideelen Ladungsverschiebung Qi die momentan zu jedem Zeitabschnitt wirkende Kraft F auf die Schaltmatte bestimmen bzw. berechnen. Diese lässt sich an einem Display 5 ausgeben, anzeigen oder abspeichern. Gegebenenfalls wird mittels eines Eichfaktors direkt aus der ideelen Ladung Qi die momentan auf die Schaltmatte, insbesondere auf die Piezoschaltmatte einwirkende Kraft F bestimmt oder angezeigt. Hierdurch lässt sich die Kraft F exakt und genau betragsmässig bestimmen. Dies hat zum Vorteil, dass zu jeder Zeit bestimmt werden kann, welche Kraft F direkt an der Schaltmatte 1 anliegt.

Beispielsweise lassen sich hierdurch bestimmte Toleranzen setzen, bei welcher Kraft F ein ganz bestimmtes Signal bspw. in der Sicherheitstechnik weitergeleitet wird oder als Signal geeignet ist, um einem bestimmten Vorgang, bspw. das Öffnen von Türen oder das Schliessen von Türen zu bestimmten.

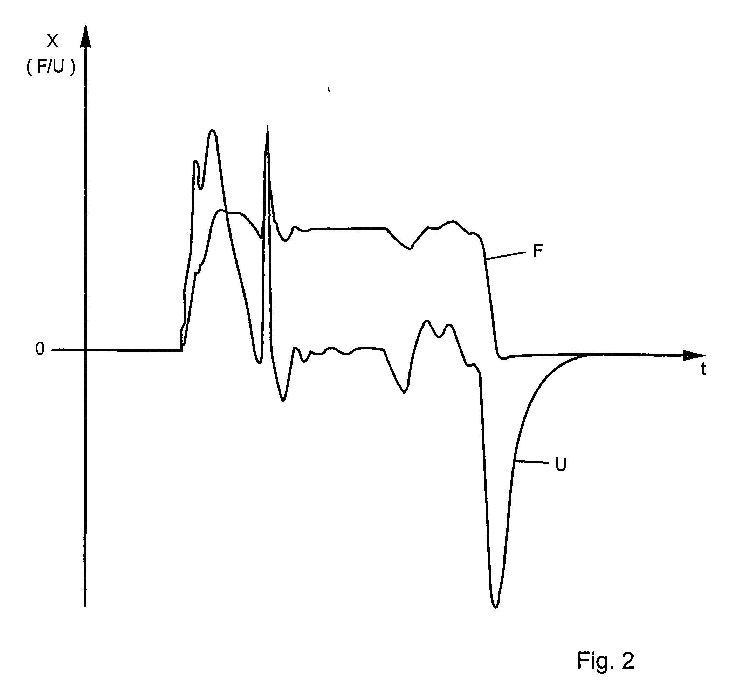

In dem Ausführungsbeispiel gemäss Figur 2 ist in dem Diagramm ein Kraftverlauf sowie ein Verlauf der Spannung über die Zeit aufgezeigt, bei welchem eine Schaltmatte 1 bspw. mit Druck beaufschlagt wird.

Hierdurch wird ein grosse Ausgangsspannungssignal U erzeugt, wobei dieses Ausgangsspannungssignal U nach einem Kraftanstieg der Kurve U durch Ladungsabfluss über den Signalverstärker 4 wieder abfällt.

Die resultierende Kurve F des tatsächlichen Kraftverlaufes wird in oben beschriebener Weise rechnerisch ausgeglichen.

Auch eine negatives Signal der Ausgangsspannung U, bspw. wenn die Kraft F schlagartig nachlässt, wird in oben beschriebener Weise rechnerisch ausgeglichen, in dem die Kraft F in jedem Zeitabschnitt richtig berechnet wird und die tatsächliche Kraft F über die Ladungsverschiebung ermittelbar ist.

| **Positionszahlenliste** | | | | | |
|---|---|---|---|---|---|
| 1 | Schaltmatte | 34 | | 67 | |
| 2 | Element | 35 | | 68 | |
| 3 | Folie | 36 | | 69 | |
| 4 | Signalverstärker | 37 | | 70 | |
| 5 | Display | 38 | | 71 | |
| 6 | | 39 | | 72 | |
| 7 | | 40 | | 73 | |
| 8 | | 41 | | 74 | |
| 9 | | 42 | | 75 | |
| 10 | | 43 | | 76 | |
| 11 | | 44 | | 77 | |
| 12 | | 45 | | 78 | |
| 13 | | 46 | | 79 | |
| 14 | | 47 | | | |
| 15 | | 48 | | | |
| 16 | | 49 | | | |
| 17 | | 50 | | | |
| 18 | | 51 | | | |
| 19 | | 52 | | | |
| 20 | | 53 | | | |
| 21 | | 54 | | | |
| 22 | | 55 | | F | Kraft |
| 23 | | 56 | | | |
| 24 | | 57 | | MC | Microprozessor |
| 25 | | 58 | | | |
| 26 | | 59 | | Qmess | Ladungsverschiebung |
| 27 | | 60 | | | |
| 28 | | 61 | | Qab | zurückfliessende Ladung |
| 29 | | 62 | | | |
| 30 | | 63 | | | |
| 31 | | 64 | | | |
| 32 | | 65 | | | |
| 33 | | 66 | | | |

## Patentansprüche

1. Verfahren zum Bestimmen von Signalen, Gewichten, Kräften auf Schaltmatten, insbesondere auf kraft- oder druckbeaufschlagte Piezoschaltmatten, bei welchem ein Ausgangssignal, insbesondere eine Potentialdifferenz durch Druckbeaufschlagung erzeugt wird, welches ggf. zur Kraftmessung verstärkt wird,
**dadurch gekennzeichnet,**
**dass** zur permanenten, kontinuierlichen Bestimmung von Signalen, von Gewichten, von Kräften die momentane Ladungsverschiebung (Qmess) ermittelt und zu dessen Kompensierung eine am Signalverstärker (4) zurückfliessende Ladung (Qab) zur Ermittlung der tatsächlichen ideelen Ladungsverschiebung (Qi) dazu addiert wird.

2. Verfahren zum Bestimmen von Signalen, Gewichten, Kräften auf Schaltmatten, insbesondere auf Kraft- oder druckbeaufschlagte Piezoschaltmatten, bei welchem ein Ausgangssignal, insbesondere eine Potentialdifferenz durch Druckbeaufschlagung erzeugt wird, welches ggf. zur Kraftmessung verstärkt wird, **dadurch gekennzeichnet, dass** zur Bestimmung einer über einen Signalverstärker (4) zurückfliessende Ladung (Qab) an ein Ausgang des Signalverstärkers (3) mittels eines Microprozessors (MC) kontinuierlich überwacht wird.

3. Verfahren nach Anspruch 1 oder 2, **dadurch gekennzeichnet, dass** die über den Verstärkereingang zurückfliessende Ladung (Qab) über jeden Zeitabschnitt ermittelt wird.

4. Verfahren nach Anspruch 3, **dadurch gekennzeichnet, dass** die über den Verstärkereingang zurückfliessende Ladung (Qab) mittels des Microprozessors (MC) über jeden Zeitabschnitt unter Berücksichtigung von Verstärkungsfaktoren und Eingangswiderstand des Signalverstärkers (4) berechnet wird.

5. Verfahren nach wenigstens einem der Ansprüche 1 bis 4, **dadurch gekennzeichnet, dass** die über den Signalverstärker (4) geflossene Ladung (Qab) sowie die momentane Ladungsverschiebung am Signalmessverstärker (Qmess) in jedem Zeitabschnitt mittels des Microprozessors (MC) zur Berechnung der ideelen Ladungsverschiebung (Qi) ermittelt wird.

6. Verfahren nach wenigstens einem der Ansprüche 1 bis 5, **dadurch gekennzeichnet, dass** aus der berechneten ideelen Ladungsverschiebung (Qi) die momentan auf die Schaltmatte (1) einwirkende Kraft oder das momentan einwirkende Gewicht ggf. mittels eines Eichfaktors in jedem Zeitabschnitt berechnet und permanent über die Zeit ausgegeben wird.

7. Verfahren nach wenigstens einem der Ansprüche 1 bis 6, **dadurch gekennzeichnet, dass** über jeden Zeitabschnitt die ideele Ladungsverschiebung (Qi) mittels des Microprozessors (MC) ermittelt und hierdurch die auf die Schaltmatte (1) einwirkende Kraft über jeden Zeitabschnitt bestimmt und ermittelt wird.

8. Verfahren nach wenigstens einem der Ansprüche 1 bis 7, **dadurch gekennzeichnet, dass** zur Bestimmung der ideelen Ladungsverschiebung (Qi) in jedem Zeitabschnitt bei einem endlichen Eingangswiderstand des Signalverstärkers (4), die über den Signalverstärker zurückgeflossene Ladung (Qab) mit der tatsächlich gemessenen Ladungsverschiebung (Qmess) am Signalverstärker addiert wird, wobei die Summe aus der Ladungsverschiebung (Qmess) und (Qab) über jeden Zeitabschnitt gebildet wird.

9. Verfahren nach Anspruch 8, **dadurch gekennzeichnet, dass** die ermittelt, ideele Ladungsverschiebung (Qi) proporzional zur Kraft (F) auf die Schaltmatte (1) ist.

10. Verfahren nach wenigstens einem der Ansprüche 1 bis 9, **dadurch gekennzeichnet, dass** die zurückgeflossene Ladung (Qab) sowie die am Signalverstärker (4) momentan anliegende Ladungsverschiebung (Qmess) über die Spannung an der Schaltmatte (1) sowie über die Kapazität der Schaltmatte (1) bestimmt bzw. über die Zeit gemessen werden.
